(19) Europäisches Patentamt
European Patent Office
Office européen des brevets

(11) **EP 2 008 115 B1**

(12) **FASCICULE DE BREVET EUROPEEN**

(45) Date de publication et mention
de la délivrance du brevet:
**03.08.2016 Bulletin 2016/31**

(21) Numéro de dépôt: **07731906.9**

(22) Date de dépôt: **18.04.2007**

(51) Int Cl.:
***G01R 31/00*** *(2006.01)*

(86) Numéro de dépôt international:
**PCT/FR2007/051130**

(87) Numéro de publication internationale:
**WO 2007/119030 (25.10.2007 Gazette 2007/43)**

(54) **PROCÉDÉ ET DISPOSITIF DE CARACTÉRISATION DE LA SENSIBILITÉ AUX INTERACTIONS ÉNERGÉTIQUES DANS UN COMPOSANT ÉLECTRONIQUE**

VERAFHREN UND EINRICHTUNG ZUR CHARAKTERISIERUNG DER EMPFINDLICHKEIT GEGENÜBER ENERGIEWECHSELWIRKUNGEN IN EINER ELEKTRONISCHEN KOMPONENTE

METHOD AND DEVICE FOR CHARACTERISING SENSITIVITY TO ENERGY INTERACTIONS IN AN ELECTRONIC COMPONENT

(84) Etats contractants désignés:
**ES GB IT**

(30) Priorité: **19.04.2006 FR 0651382**

(43) Date de publication de la demande:
**31.12.2008 Bulletin 2009/01**

(73) Titulaire: **Airbus Group SAS**
**31700 Blagnac (FR)**

(72) Inventeurs:
• **MILLER, Florent**
**F-75005 Paris (FR)**

• **BUARD, Nadine**
**F-92190 Meudon (FR)**
• **LAHOUD, Imad**
**75009 Paris (FR)**
• **CARRIERE, Thierry**
**78510 Triel Sur Seine (FR)**
• **HEINS, Patrick**
**81140 Castelnau De Montmiral (FR)**

(74) Mandataire: **Ipside**
**29, rue de Lisbonne**
**75008 Paris (FR)**

(56) Documents cités:
**WO-A-2005/022180    GB-A- 2 248 965**

**EP 2 008 115 B1**

**Description**

La présente invention a pour objet un procédé et un dispositif de mesure d'interactions énergétiques dans un composant électronique. Le but de l'invention est de mieux caractériser les composants électroniques en ce qui concerne de telles agressions.

Les environnements radiatifs naturels ou artificiels (neutrons, protons, ions lourds, flash X, rayons gamma) peuvent perturber le fonctionnement des composants électroniques. Ces perturbations sont dues à des interactions entre la matière et les particules de l'environnement radiatif. Une des conséquences est la création de courants parasites dans le composant. Selon l'endroit où ont lieu les interactions entre la matière et les particules, les courants parasites seront plus ou moins importants. Ceci traduit la présence de zones localisées de collection de charges dans le composant.

De telles agressions par des ions lourds et des protons sont typiquement rencontrées, dans l'espace, par des satellites et des lanceurs. A des altitudes moins élevées où évoluent des avions, on note surtout la présence de neutrons. Sur le sol terrestre, de telles agressions peuvent aussi être rencontrées et affecter les composants électroniques embarqués dans des appareils portables, ou dans des voitures.

La connaissance de la forme et de la position à l'intérieur du composant des zones de collection de charges est un des paramètres clefs pour l'étude de la sensibilité du composant vis à vis des environnements radiatifs, mais également vis à vis de tout type de phénomène initié par la création de charges parasites dans les composants électroniques, comme par exemple par les décharges électrostatiques (ESD).

Pour pouvoir prédire le comportement des composants vis à vis des ions lourds, des neutrons et des protons, notamment pour des applications spatiales ou aéronautiques, il est nécessaire de connaître non seulement l'étendue surfacique des zones de collection de charges, mais également leurs caractéristiques en profondeur, ce qui suppose de pouvoir établir des cartographies à trois dimensions.

Classiquement, pour évaluer la sensibilité d'un composant électronique aux radiations, le composant est soumis à un flux de particules. et les perturbations sont comptabilisées. Dans la mesure où tout le composant est irradié, ce type de test ne permet pas de remonter à la localisation des zones de collection de charges. De plus, ces tests sont relativement onéreux car il y a relativement peu d'installations dans le monde susceptibles de produire des flux de particules. Enfin, même si les particules utilisées en accélérateur de particules sont les mêmes que celles qui sont présentes dans l'environnement radiatif, les niveaux d'énergies peuvent être différents. Ceci peut conduire à d'importantes erreurs notamment en ce qui concerne la pénétration des particules dans le composant.

Des faisceaux de petites tailles peuvent être extraits de la sortie d'accélérateurs de particules. Il est alors possible d'utiliser ces micro faisceaux pour cartographier les zones de sensibilités d'un composant. Cette cartographie s'effectue dans un plan et elle ne permet que de révéler de manière surfacique la localisation des zones de collection de charges. Aucune information sur la localisation en profondeur de la zone sensible n'est obtenue par ce type de test.

Jusqu'à maintenant, le laser était principalement utilisé comme un outil de pré-caractérisation de la sensibilité des composants aux radiations. Tout comme les particules de l'environnement radiatif, le laser peut, lorsque sa longueur d'onde est appropriée, générer des courants parasites à l'intérieur des composants.

Le laser présente un avantage très intéressant pour l'étude de l'effet des radiations. Dans la mesure où la résolution spatiale du laser peut atteindre des dimensions relativement faibles par rapport aux structures élémentaires contenues dans les composants électroniques, il est possible, tout comme dans le cas du micro faisceau, de cartographier un composant électronique et d'identifier ses zones de collection de charges. La limitation est jusqu'à lors, la même que pour le micro faisceau, c'est à dire, l'impossibilité de remonter à une information sur la localisation en profondeur de la zone sensible dans le composant ainsi que sur son épaisseur.

Pour contrer cet inconvénient, il est connu une méthode s'appuyant sur l'absorption non linéaire (à deux photons). Néanmoins, la source laser utilisée n'est pas industrielle et la méthode très difficile à mettre en oeuvre ailleurs qu'en laboratoire.

Le document GB 2248965 décrit un procédé de test de semi-conducteurs.

L'objet de l'invention est une méthode permettant de déterminer la position en profondeur et l'épaisseur des zones de collection des charges à l'intérieur d'un composant électronique quelconque, en utilisant une sonde laser à longueur d'onde fixe dans la bande d'absorption du semi-conducteur. A titre essentiel, le rayonnement laser de l'invention est focalisé. Pour explorer l'épaisseur du composant, on déplace alors le foyer du rayonnement laser dans l'épaisseur du composant. Le déplacement peut être réalisé par translation, ou par focalisation plus ou moins convergente. La description qui suit présentera le cas de la translation. Pour la variation de convergence, il convient de choisir d'autres modes de calcul, ils sont toutefois à la portée de l'homme du métier, s'agissant de simples constructions optiques.

La méthode de l'invention peut être utilisée pour déterminer la sensibilité de composants électroniques vis à vis des radiations à partir des tests laser : les informations sur la géométrie des zones de collection de charges du composant servent alors de paramètres d'entrée dans des simulations de prédiction d'erreur vis à vis des particules (ions lourds, neutrons, protons...).

Enfin, la méthode de l'invention permet de mettre en évidence les faiblesses d'une technologie pour la tenue aux radiations, ce qui est une information importante pour le développement des nouveaux composants en ce qui concerne leur procédé de fabrication.

On notera que les sources laser utilisées dans l'invention sont des sources peu coûteuses, très fiables, disponibles commercialement, donc adaptées à un environnement industriel.

L'invention a donc pour objet un procédé de caractérisation de la sensibilité aux interactions énergétiques dans un composant électronique dans lequel,

- on met le composant électronique en service,
- on excite le composant électronique ainsi mis en service à l'aide d'un rayonnement laser,
- on mesure un défaut de fonctionnement du composant électronique mis en service correspondant à cette excitation, et
- on établit une carte de localisations d'intérêt dans le composant où ces interactions sont les plus fortes, caractérisé en ce que
- on focalise le rayonnement laser à différentes profondeurs dans le composant et
- on mesure les interactions énergétiques pour ces différentes profondeurs.

L'invention sera mieux comprise à la lecture de la description qui suit et à l'examen des figures qui l'accompagnent. Celles-ci ne sont données qu'à titre indicatif et nullement limitatif de l'invention. Les figures montrent :

- Figure 1 : Une représentation schématique d'un dispositif utilisable pour mettre en oeuvre le procédé de l'invention ;
- Figure 2 : Une représentation graphique des effets de décalage de la focalisation du laser de l'invention ;
- Figure 3 : Pour une zone d'intérêt selon l'invention, le relevé de l'énergie critique pour laquelle des interactions sont critiques, en fonction de la profondeur de focalisation ;
- Figure 4 : Une représentation schématique de trois exemples dans lesquels, pour une zone d'intérêt connue, l'explication de la défocalisation du laser justifie les résultats de la figure 3 ;
- Figures 5 à 7 : La représentation sur un composant des différentes zones d'intérêt et leurs correspondances, figures 6 et 7, dans les signaux détectés ;
- Figure 8 : Un relevé de puissance critique en fonction de la profondeur de défocalisation pour un deuxième type de composant ;
- Figure 9 : La représentation schématique de la démarche de simulation montrant l'exploitation de la connaissance de la localisation des zones sensibles mesurées avec l'invention, pour évaluer la sensibilité du composant aux ions lourds ou aux neutrons ou aux protons.

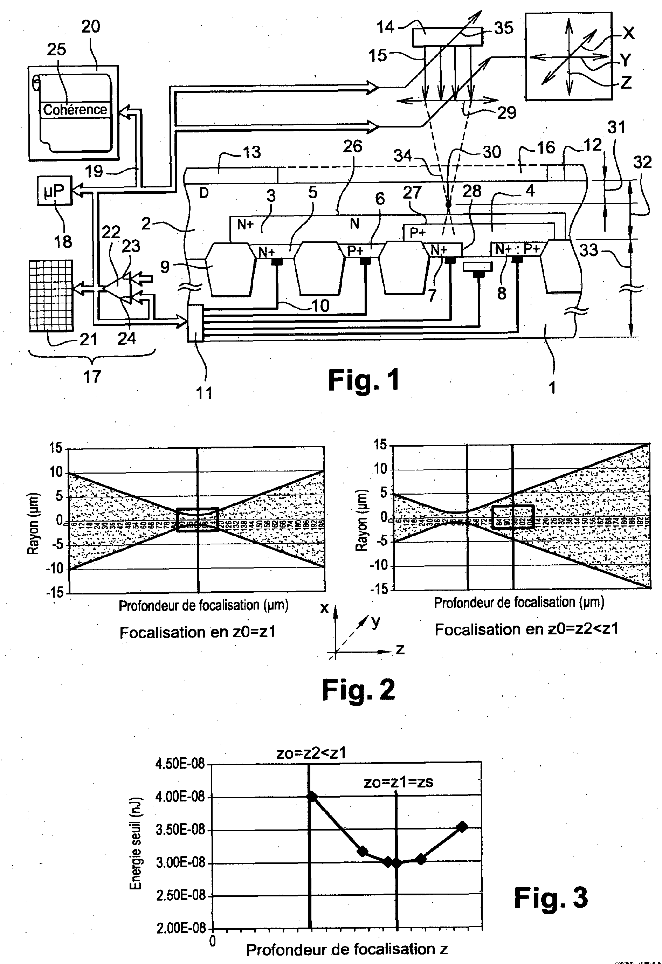

La figure 1 montre un dispositif utilisable pour mettre en oeuvre le procédé de l'invention. Le but de l'invention est de mesurer les effets d'interactions énergétiques dans un composant électronique 1. Le composant électronique 1 comporte ainsi, d'une manière connue, et présenté à l'envers, un cristal semi-conducteur 2 dans lequel sont réalisées diverses implantations: des caissons tels que 3, des puits tels que 4 dans un tel caisson 3, et des zones implantées par des impuretés telles que 5 à 8. Sans qu'il puisse y être perçue une limitation, le cristal semi-conducteur 2 est un cristal de silicium de type P dans lequel le caisson 3 est implanté avec des impuretés de type $N^+$, le puits 4 étant implanté avec des impuretés de type $P^+$, les zones 5 à 8 étant implantées avec des impuretés de différentes natures selon les fonctions électroniques et les jonctions qu'il est nécessaire de créer pour réaliser le composant électronique. Des concentrations d'impuretés dans un tel composant sont classiquement comprises entre $10^{15}$ et $10^{23}$. Les zones implantées 5 et 6 ainsi que les caissons 3 et puits 4 sont séparées les unes des autres par des barrières d'oxyde de silicium telles que 9. D'une manière connue, entre ces barrières 9 sont réalisées par vaporisation des connexions, typiquement métalliques, telles que 10 débouchant sur une interface 11 de connexion du composant électronique 1. Typiquement, la dalle semi-conductrice 2 repose par sa surface de base 12 sur une protection 13, de préférence une métallisation. Dans certains cas, la protection 13 est en un matériau de très grande dureté, par exemple en cobalt. La protection 13 est située sur une face du cristal 2 opposée à celle où sont réalisées implantations 5 à 8.

Dans l'invention, pour mesurer les défauts de fonctionnement du composant électronique qui serait soumis à des interactions énergétiques, on l'excite au moyen d'une source laser 14. Cette source laser 14 émet un rayonnement 15 qui vient agresser le composant électronique 2. De manière à favoriser cette agression, de préférence, le composant 1 est soumis à cette agression par sa base 12. De manière à favoriser cette agression, de préférence la protection 13 est ouverte (notamment par processus chimique ou mécanique) dans une fenêtre 16 par laquelle peuvent pénétrer le rayonnement 15 du laser 14.

Au moment du test, le composant électronique 1 est relié par son interface 11 à un dispositif d'alimentation et de commande 17. Le dispositif 17 comporte, d'une manière schématique, un microprocesseur 18 relié par un bus 19 de commandes, d'adresses et des données à une mémoire programme 20, à une mémoire de donnée 21, à l'interface 11 à la source laser 14 et à un système 35 d'atténuation de l'énergie laser. Le dispositif 17 comporte par ailleurs, schématiquement représenté, un comparateur 22 recevant d'une part sur une entrée de consigne 23 une grandeur électrique attendue et sur une entrée de mesure 24 des signaux électriques prélevés par l'interface 11 dans le composant 1, alors que ce dernier subit les interactions et les excitations du laser 14.

Le comparateur 22 peut pour sa part être remplacé par un sous-programme 25 de mesure de la cohérence du signal reçu du composant électronique 1 avec un signal attendu. Le fonctionnement de la mesure peut être statique : on teste dans ce cas uniquement des valeurs de potentiels et de courants disponibles sur des plots de l'interface 11. Il peut également être dynamique. Dans ce cas, le microprocesseur 18 comporte en outre une horloge qui égrène certaines opérations dont le déroulement doit subir un historique connu, et on mesure si cet historique se reproduit de manière attendue ou s'il présente des anomalies.

D'une manière classique il est connu, notamment avec le microprocesseur 18, de déplacer la source 14 dans des directions XY à la surface 12 du cristal 2. En effectuant ce déplacement, il est possible de repérer les localisations d'intérêts où on mesure que les interactions entre le rayonnement 14 et le semi-conducteur 1 sont les plus fortes, voire deviennent critiques. Mais cette connaissance est insuffisante. Elle ne donne pas de renseignement sur la profondeur.

Le trou formé par la fenêtre 16 est plus petit que l'étendue de la dalle 2 du composant 1. Le trou 16 est petit parce que, s'il devient trop grand, les conditions de fonctionnement électrique du composant 1 peuvent en être altérées. Notamment il est nécessaire que la connexion électrique de la couche 13 puisse être maintenue. Ceci étant, la trace de l'impact du rayonnement 15 sur la surface 12 et bien entendu inférieure au trou 16, sinon le balayage en X et Y de la fenêtre 16 serait inutile. Par ailleurs, malgré toutes les précautions prises, la dimension des zones d'implantation telles que 5 à 8 sont bien plus petites que la trace de l'impact du rayonnement laser 15. La figure 1 ne le montre pas tout à fait pour des raisons de commodités. Mais en pratique, la trace de l'impact est bien supérieure à la taille d'une fonction élémentaire dans le composant électronique. Par exemple, s'agissant d'une cellule mémoire de type statique, la trace de .l'impact a une surface bien supérieure à celle d'un point mémoire de cette mémoire statique.

Avec une telle technique il est connu de repérer des zones d'intérêt dans le composant 1 au sens où ces zones sont les sièges d'interactions néfastes pour le fonctionnement du composant 1. Le but de l'invention est de connaître précisément la partie du composant qui est le siège d'une interaction néfaste. Typiquement, la question se pose de savoir si la partie concernée est celle du fond 26 du caisson 3, du fond 27 du puits 4, ou encore de la zone de jonction 28 d'une des zones implantées 5 à 8. La connaissance de cette profondeur peut amener à modifier le niveau d'implantation d'impuretés dans des différentes zones pour durcir le composant à l'égard de ces interactions.

Dans l'invention, pour obtenir ce résultat, on a prévu de focaliser le rayonnement laser 15 à l'aide d'un dispositif de focalisation, ici schématiquement représenté par une lentille 29, et de faire varier à l'aide de cette lentille 29 une profondeur de focalisation Z d'un foyer 30 du rayonnement 15 ainsi focalisé. Par exemple, une profondeur 31 montrée est ici située sous la surface 12 mais au-dessus de la surface du fond 26 du caisson 3. Une hauteur 32 du cristal du semi-conducteur 2 est en général de l'ordre de 300 micromètres, alors que celle utilisée pour les oxydes de séparation 9 et la structure de connexion peut être de l'ordre de 600 micromètres. On tient bien entendu compte de l'indice de réfraction de cristal 2, différent de l'indice de réfraction de l'air. Ceci n'est pas montré sur la figure 1 où le rayonnement focalisé présente des rayons rectilignes 34. Selon l'invention, pour chaque profondeur de focalisation on mesure les interactions énergétiques du rayonnement sur le composant 1. Le principe de cette mesure est le suivant.

Une fois que la source laser 14 est placée en regard d'une zone d'intérêt (mesurée comme dit précédemment), pour une première focalisation donnée, par exemple sur la surface 12, on ajuste par des commandes transmises à l'atténuateur 35, à l'aide du microprocesseur 18 et du bus 19, le niveau d'atténuation de l'énergie laser et on commande, à l'aide du microprocesseur 18 et du bus 19, la source 14 pour effectuer un impulsion laser. La diminution du niveau d'atténuation de l'atténuateur 30 provoque une croissance de l'énergie du laser. Cette croissance a pour résultat que la puissance laser dissipée dans le composant 1 augmente. En pratique, cette administration d'excitations énergétiques peut être pulsée (notamment afin de ne pas échauffer trop fortement le composant par une illumination continue). En outre, de préférence mais ce n'est pas une obligation, la modification de puissance peut être effectuée pas à pas. Du point de vue expérimental, on part de la valeur d'énergie (de puissance) laser la plus élevée et on la diminue jusqu'à obtenir la valeur critique (mais l'inverse est ainsi possible : partir de la valeur d'énergie la plus faible et l'augmenter progressivement). Pour chaque impulsion on mesure, à la fin de l'impulsion, la cohérence du signal lu dans le composant 1 par rapport à un signal attendu. Si cette cohérence est bonne, on diminue l'atténuation. A un moment donné, on obtient une puissance critique, celle pour laquelle, pour la première fois, la réponse électronique du composant 1 n'est plus celle attendue. On note la valeur de cette puissance critique.

Puis on change la focalisation de la source laser, par exemple en déplaçant la lentille 29 en direction du composant 1 (ou éventuellement en utilisant une lentille à focale variable), de manière à ce que le foyer 30 pénètre plus avant dans le cristal 2. Pour cette autre position en profondeur de ce foyer 30, on réitère l'opération de croissance (on peut aussi procéder par décroissance) et on obtient une nouvelle valeur de puissance critique. En agissant ainsi, on peut relever une cartographie en profondeur, et non plus seulement en surface, du défaut de fonctionnement du composant électronique 1.

En effet, la répartition spatiale d'un faisceau laser au foyer d'un objectif est modélisé de façon idéale par une gaussienne dans un plan, et par une exponentielle décroissante en profondeur. A deux dimensions, la densité d'énergie $I_{laser}$ du faisceau se propageant dans un milieu d'indice n s'exprime comme :

$$I_{laser} = Io\, e^{\frac{-2\,(x+y)^2}{\omega(z)^2}}\, e^{-\alpha z}\ \text{et}\ \omega(z) = \omega_o{}^2 \left(1 + \left(\frac{\lambda\,(z - z_o)}{p\,n\,\omega_o{}^2}\right)^2\right)$$

avec : $\omega_o$ = largeur du faisceau au point de focalisation (ici en z = $z_o$).

n = indice du milieu de propagation.

lo = densité d'énergie laser incidente avant entrée dans le semi-conducteur en J/cm$^2$)

Après focalisation, le faisceau se ré-élargit rapidement dès que l'on s'éloigne du point de focalisation. Quand le faisceau pénètre dans un semi-conducteur, par exemple du silicium, les propriétés de réfraction dues à la différence d'indices entre l'air ($n_{air}$ = 1) et le silicium ($n_{Si}$ = 3,5) font que si, en l'absence de l'interface Air/Silicium située à la position z = 0, le faisceau était focalisé en z = $z_{o'}$, alors en présence de l'interface, le point de focalisation serait repoussé à la profondeur z = $z_o$, avec comme rayon caractéristique défini à 1/e$^2$ du maximum d'intensité, le paramètre $\omega_{oSi}$. Ce paramètre est appelé « beam waist » en anglais ou gorge du faisceau en français.

On peut montrer à partir des propriétés des faisceaux gaussiens et de leur transmission aux interfaces que :

$$\omega_{osi} = \omega_{oair} = \omega_o$$
$$z_o = n_{si}\ x\ z_o{}'$$

Le faisceau se focalise à une profondeur $z_o$ dans le silicium avec un rayon caractéristique défini à 1/e$^2$ du maximum d'intensité identique à celui qu'il aurait eu sans interface. Une variation de dz dans le repère normal se traduira donc par une variation de $n_{si}$.dz dans le silicium.

La figure 2 schématise deux cas de propagation dans le silicium avec des focalisations à des profondeurs différentes. Les photons du faisceau laser sont capables, si leur énergie hc/$\lambda$ est supérieure à la barrière de potentiel dans le cristal 2, de créer des charges libres dans le semi-conducteur tout le long de leur passage

On peut montrer que la densité volumique de charges (par exemples les électrons symbolisés par n) introduits par un faisceau laser de densité d'énergie incidente lo jusqu'à la profondeur z dans le semi-conducteur est :

$$n(x, y, z) = \eta.(1 - R).\frac{\lambda}{hc}\,\alpha.I_{laser}\,(x, y, z)$$

avec :

h = constante de planck.

c = célérité de la lumière.

$\lambda$ = longueur d'onde laser.

(1 - R) $I_{laser}$ = densité d'énergie laser pénétrant dans le semi-conducteur.

$\alpha$ = coefficient d'absorption du semi-conducteur.

$\eta$ = efficacité quantique $\simeq$ 1.

Supposons que la zone sensible de collection des charges soit matérialisée par le rectangle et soit localisée à z=zs en profondeur. Le faisceau laser créera davantage de charges dans la zone de collection quand il est focalisé en zo=z1=zs que dans le cas où il est focalisé en zo=z2 (avec z2 différent de z1). La collection des charges sera donc plus efficace dans le premier cas, et l'énergie laser nécessaire pour obtenir une quantité donnée de charges collectées (appelée par la suite énergie critique) diminuera. Cette énergie critique correspond, pour une durée donnée d'impulsion, à une puissance critique. Si la courbe de l'énergie critique, dite aussi énergie seuil, en fonction de la profondeur de focalisation zo est tracée dans la configuration de la figure 2, elle aura l'allure représentée sur la figure 3. C'est l'exploitation de cette courbe (recherche du minimum) qui fournit la profondeur de la zone sensible de collection (ici zs). En effet, en z2 (<z1), il faut plus de puissance au laser 14 pour dérégler le fonctionnement du composant 1. En z1, il en faut moins. Donc la zone d'altitude z1 est plus sensible que la zone d'altitude z2.

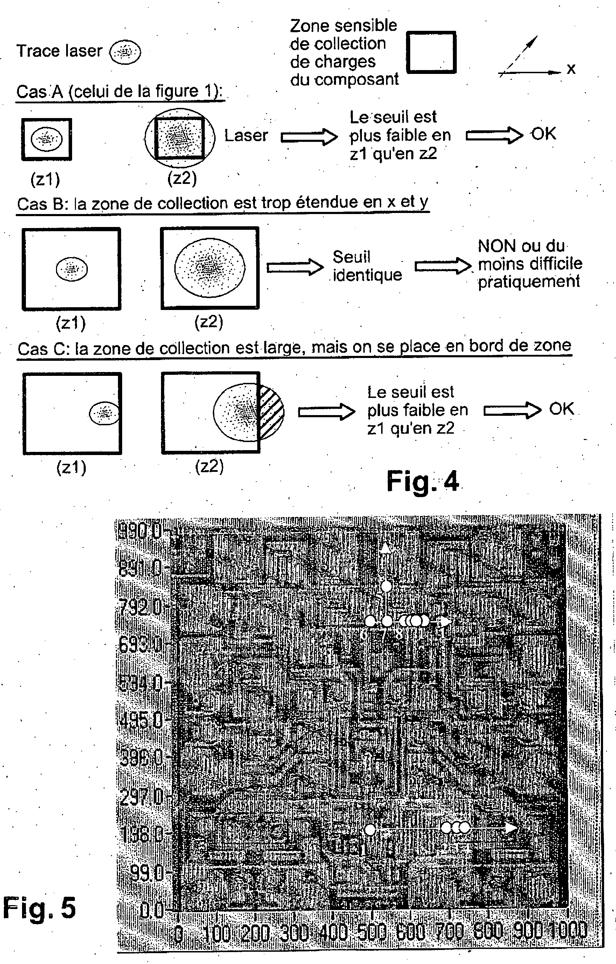

Si l'on considère les deux autres directions X et Y, on remarquera que cela ne se produit pas dans tous les cas de figure. Sur la figure 4 en effet, on montre trois cas de figure A, B et C. Dans le cas A, la zone de collection est plus petite en z2, et plus grande en z1, que la taille du faisceau laser (représenté par un disque sur la figure). Donc le seuil critique sera moins élevé à l'altitude z1 qu'à l'altitude z2. Pour le cas B, comme la zone sensible est bien plus grande que la taille du faisceau laser, le seuil critique sera le même partout. L'expérience n'est pas concluante, sauf à utiliser une focale bien plus petite pour se remettre dans les conditions du cas A. Dans le cas C, pour lequel la zone sensible est du même type que celle du cas B, (pour une convergence de focalisation donnée), on constate que la méthode permet de bien détecter les altitudes des bords de la zone sensible (notamment du fait de la neutralisation d'une partie du rayonnement laser qui atteint une zone où il ne produit pas de courant parasites dans le composant). Dans ce cas, la puissance critique est plus grande. Le bord de la zone correspond donc précisément à la position en X et Y de la source 14 pour laquelle la puissance utile à révéler le phénomène commence à être plus grande par rapport à une localisation voisine.

Ceci étant, il n'est pas nécessaire de placer l'exploration focale dans une zone d'intérêt préalablement localisée en surface, ou plus généralement en X et Y, avant de commencer l'exploration en profondeur, en Z. Typiquement, l'exploration peut commencer à n'importe quel endroit, les coordonnées X, Y et Z des diverses focalisations étant déterminée selon une stratégie quelconque, tant en profondeur que dans le plan XY, voire aléatoire. De même, pour modifier la profondeur de focalisation dans le composant, plutôt que de déplacer la lentille 29 par rapport au composant, on peut choisir de modifier, par exemple par pas, la longueur d'onde de rayonnement du laser.

Il est nécessaire d'utiliser un laser pour lequel le matériau étudié ne soit pas transparent. L'énergie du photon laser doit être supérieure à la barrière de potentiel, à la bande interdite du semiconducteur. Dans le cas du silicium, il faut que la longueur d'onde du laser soit plus petite que 1,1 micromètre. D'un autre côté, il faut s'assurer que la pénétration du laser dans le silicium est suffisamment importante pour pouvoir exciter des zones enterrées en profondeur.

La durée de l'impulsion laser n'a pas de réelle importance pour cette méthode dans la mesure où la durée d'impulsion n'affecte que le seuil de déclenchement du phénomène. Dans la mesure où le laser est suffisamment énergétique, le choix de la durée d'impulsion n'est pas critique

La méthode est d'autant plus sensible que la taille de la trace, du spot, laser est petite. Pour une longueur d'onde de 1,06 micromètres, on a pu montrer par exemple qu'une taille de spot de 4 micromètres était adaptée à la méthode.

Le faisceau laser peut être incident par la face avant du composant (côté des électrodes) ou par la face arrière (le substrat 2). Le faisceau laser ne pénétrant pas les métallisations, l'irradiation par face arrière est préférable pour révéler toutes les zones sensibles. Néanmoins la méthode s'applique dans les deux cas.

L'énergie seuil est définie comme l'énergie laser nécessaire pour obtenir une quantité donnée de charges collectées, appelée charge critique. Sans que cela ne soit limitatif des effets qu'il est possible d'étudier, pour des composants analogiques, cela pourra se traduire par un niveau donné de courant transitoire en sortie ou par le déclenchement d'une défaillance destructive. Pour les mémoires SRAM, cela pourra se traduire comme l'énergie ou la charge critique permettant le changement d'état du bit ou le déclenchement d'un phénomène parasite dit de latchup.

La première étape consiste donc à réaliser une cartographie laser à deux dimensions dans les directions X et Y du composant. L'ensemble de la surface du composant est balayée par le laser. Pour chaque position du balayage, l'énergie laser pour laquelle le phénomène observé se déclenche est enregistrée. Un exemple de cartographie laser présentant deux zones sensibles distinctes est présenté en figure 5. La recherche en profondeur est alors effectuée selon le principe expliqué ci-dessus sur une certain nombre de points intéressants. Typiquement elle est effectuée pour les points 1 à 4 dans un cas et 5 à 11 dans l'autre.

La méthode est appliquée ici à un composant électronique analogique de type comparateur. Deux zones de collection de charges ont été identifiées par la cartographie laser. Pour chacune de ces deux zones étendues spatialement, des études de la sensibilité en profondeur ont été menées en différents points, au centre et en bord de ces zones de collection de charges.

Comme précisé ci-dessus, et comme confirmé dans la partie ci-après qui présente l'aspect théorique de la méthode, le minimum de la courbe $E_{seuil}$=f(profondeur de focalisation) correspond à la position en profondeur de la zone sensible.

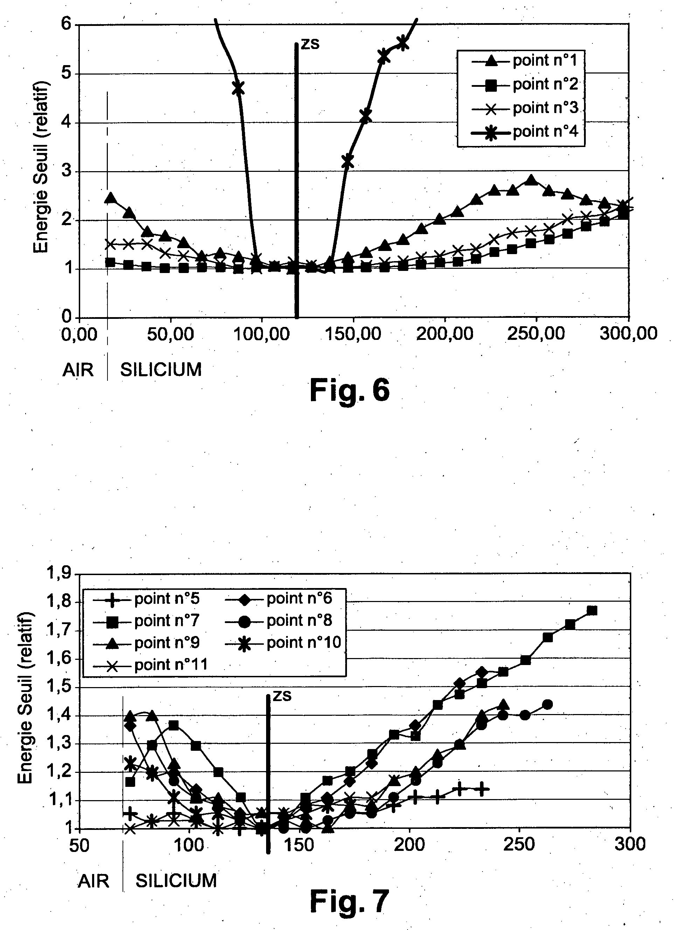

La figure 6 montre surtout, avec la courbe relative au point 4 du premier cas, qu'il est plus facile de déterminer la position en profondeur du bord de la zone sensible. Pour les points 1 à 3, la détection du minimum n'est pas aussi flagrante, puisque le gradient est plus faible. Pour la zone des points 5 à 11, figure 7, les conclusions sont les mêmes. Le point 7 permet de définir une altitude de sensibilité à 130 micromètres. Si on retranche l'écart de 60 micromètres entre la lentille 29 et la surface 12, on obtient une altitude de 70 micromètres. En se servant ensuite du rapport d'indice de réfraction air-silicium, on aboutit à une profondeur de zone sensible de 240 micromètres environ.

En tenant compte de l'indice de réfraction du silicium et du décalage de l'abscisse de la courbe, la position du minimum montre que la zone sensible est située à environ 340 micromètres de profondeur à partir de la face 12 arrière du composant (interface Air-Silicium) pour la zone des points 1 à 4, et à 240 micromètres de profondeur pour la zone des points 5 à 11.

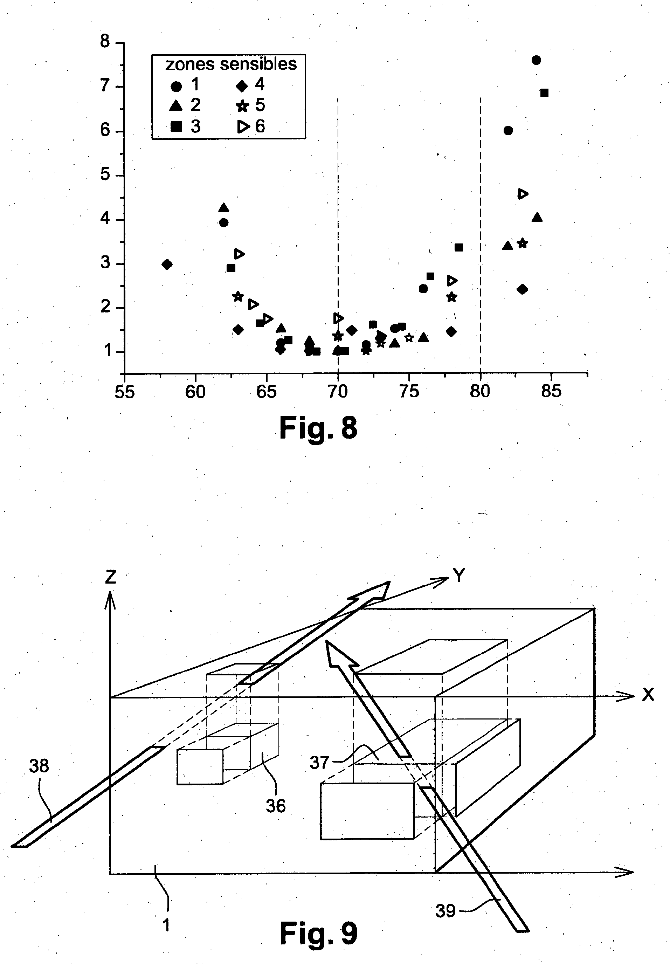

Dans le cas des composants de type mémoire vive statique, SRAMs, la taille du faisceau laser est telle que, quelle que soit la position du laser par rapport à un point mémoire, $\omega(z)$ est grand par rapport aux dimensions du point mémoire. Ainsi, des variations sur $\omega(z)$ entraîneront des variations sur l'énergie seuil. On obtient alors, selon la figure 8, une détection conforme au cas C de la figure 4. La méthode fonctionne bien.

Sur le plan théorique, la zone sensible d'épaisseur h et de côtés a, b, est située en (xs, ys, zs). Le faisceau laser est focalisé en (xo,yo,zo) dans le silicium.

En se plaçant dans les hypothèses du modèle RPP (Rectangular Parallelepiped), c'est à dire que la zone de collection de charges est assimilée à un parallélépipède rectangle, on peut calculer le nombre de charges générées dans ce parallélépipède rectangle de côté a, b et h positionné à la profondeur $z_s$ en xs, $y_s$:, par un faisceau gaussien focalisé en (xo=0, yo=0, zo).

$$n_{ch\arg e} = \eta \cdot \frac{\lambda.(1-R).\alpha}{h.c} \cdot I_0 \int_{z_s-\frac{h}{2}}^{z_s+\frac{h}{2}} .e^{-\alpha.z} \cdot \frac{\omega_0^2}{\omega(z)^2} \cdot \int_{x_s-\frac{a}{2}}^{x_s+\frac{a}{2}} .e^{-\frac{2x^2}{\omega(z)^2}} \cdot \int_{ys-\frac{b}{2}}^{ys+\frac{b}{2}} .e^{-\frac{2y^2}{\omega(z)^2}} ..dx.dy.dz$$

où $I_0 = \dfrac{2.E_0}{\pi.\omega_0^2}$ et Eo, énergie laser incidente en z=0.

L'intégration de l'expression précédente donne :

$$n_{charge} = \eta \cdot \frac{4\lambda.(1-R)\alpha}{hc} E_o \int_{z_s-\frac{h}{2}}^{zs+\frac{h}{2}} e^{-\alpha.z} \left[ erf\left( \frac{\sqrt{2}}{\omega(z)} .(\frac{a}{2} - xs) \right) - erf\left( \frac{\sqrt{2}}{\omega(z)} .(\frac{-a}{2} - x_s) \right) \right] \left[ erf\left( \frac{\sqrt{2}}{\omega(z)} .(\frac{b}{2} - ys) \right) - erf\left( \frac{\sqrt{2}}{\omega(z)} .(\frac{-b}{2} - ys) \right) \right] dz$$

$$\omega(z)^2 = \omega_o^2 \left[ 1 + \frac{\lambda(z-zo)^2}{\pi.n\omega_o^2} \right]^2$$

Pour l'énergie laser seuil $E_o = E_{seuil}$ correspondant à la charge critique $n_{charge} = Q_{crit}$, il viens !

$$E_{seuil} = \frac{Q_{critique}}{\eta \cdot \dfrac{4\lambda.(1-R)\alpha}{hc} \cdot \displaystyle\int_{z_s-\frac{h}{2}}^{z_s+\frac{h}{2}} e^{-\alpha.z} \left[ erf\left( \frac{\sqrt{2}}{\omega(z)} .(\frac{a}{2} - x_s) \right) - erf\left( \frac{\sqrt{2}}{\omega(z)} .(\frac{-a}{2} - x_s) \right) \right] \left[ erf\left( \frac{\sqrt{2}}{\omega(z)} .(\frac{b}{2} - y_s) \right) - erf\left( \frac{\sqrt{2}}{\omega(z)} .(\frac{-b}{2} - y_s) \right) \right] dz}$$

Le calcul de l'intégrale se fait par exemple par la méthode des trapèzes. Cette fonction décrit l'évolution de l'énergie seuil en fonction de la profondeur de focalisation. Le tracé de cette expression fournit par exemple la courbe de la figure 3.

La fonction Erf(x) tend vers 1 lorsque son argument est grand. Pour observer des variations de l'énergie seuil $E_{seuil}$, il faut donc que les rapports :

$$\left( \frac{\sqrt{2}}{\omega(z)} .(\frac{a}{2} - x_s) \right) \text{ et } \left( \frac{\sqrt{2}}{\omega(z)} .(\frac{b}{2} - y_s) \right)$$

varient, ce qui est effectif dans les cas A et C de la figure 4, mais pas en B.

Ainsi, dans le cas d'une zone sensible pour laquelle les dimensions a et b sont bien plus grandes que w(z) (quelle que soit la profondeur) (cas B), il n'y aura aucune variation de l'énergie seuil.

Par contre, pour des $\omega(z)$ identiques, si les tirs laser ont lieu en bord de zone sensible , l'énergie seuil varie car alors $\left(\dfrac{\sqrt{2}}{\omega(z)}.(\dfrac{a}{2}-x's)\right)$ et $\left(\dfrac{\sqrt{2}}{\omega(z)}.(\dfrac{b}{2}-y_s)\right)$ varient.

Supposons qu'il n'y ait qu'une seule zone sensible, positionnée à une profondeur $z_s$ et d'épaisseur h (cf. figure 8). Si l'expression de Eseuil en fonction de z est dérivée, il vient:

$$\frac{\partial Eseuil}{\partial z} = Q_{crit} \times \frac{\dfrac{\partial n_{charge}}{\partial z}}{n^2_{charge}} = Q_{crit} \times \frac{\dfrac{\partial n_{charge}}{\partial z_s} \times \dfrac{\partial z_s}{\partial z}}{n^2_{charge}}$$

Comme expliqué en 2.1.1, $\dfrac{\partial z_s}{\partial z} = n_{si}$ . La dérivée de la courbe représentant l'évolution de la charge générée en fonction de la profondeur permet donc de caractériser l'extremum de la fonction. L'expression de cette dérivée est donnée ci dessous (dans un soucis de clarté, les valeurs de $x_s$, $y_s$, a et b sont telles que : $X_6=y_s=0$ et $a=b$, mais le calcul général mènerait à des résultats identiques:

$$\frac{\partial nch\,arge}{\partial z} = n_{si} \times \eta . \frac{\lambda.(1-R)\alpha}{h.c}.Eo.\left[ e^{-\alpha.(z_s+\frac{h}{2})}\left[ erf\left( \frac{\sqrt{2}}{\omega(z_s+\frac{h}{2})}.(\frac{a}{2}) \right) \right]^2 - e^{-\alpha.(z_s-\frac{h}{2})}\left[ erf\left( \frac{\sqrt{2}}{\omega(z_s-\frac{h}{2})}.(\frac{a}{2}) \right) \right]^2 \right]$$

et $z_s=n_{si}*z$. L'extremum est donné par : $\dfrac{\partial n_{charge}}{\partial z} = 0$ , soit :

$$e^{-\alpha.h}\left[ erf\left( \frac{\sqrt{2}}{\omega(z_s+\frac{h}{2})}.(\frac{a}{2}) \right) \right]^2 = \left[ erf\left( \frac{\sqrt{2}}{\omega(z_s-\frac{h}{2})}.(\frac{a}{2}) \right) \right]^2$$

Dans la mesure où le produit $\alpha.h$ tend vers 0 {$\alpha \approx 20 cm^{-1}$ pour le silicium et un niveau de dopage inférieur à $10^{17}$ $cm^3$ et avec une longueur d'onde de 1.06 micromètre, z est de l'ordre du micromètre ou de la dizaine de micromètre), l'égalité est obtenue quand $z_s$, centre de la zone sensible en profondeur, est égal au point de focalisation du laser zo, car on a alors bien $\omega(z_0+h/2)= \omega(z_0-h/2)$.

Ainsi, le minimum de la courbe expérimentale caractérisant l'évolution de l'énergie seuil en fonction de la profondeur de focalisation, correspond bien, dans les hypothèses du modèle RPP, à la profondeur à laquelle est enterrée la zone sensible.

La figure 9 montre schématiquement la simulation des agressions des ions lourds ou autres particules. Avec l'invention, on a été capable dans le composant 1 de définir en X, en Y et Z, des positions de zones sensibles 36 et 37. Pour simplifier, on peut admettre que ces zones 36 est 37 sont sensibles, et que le reste du composant n'est pas sensible. Plus généralement, chaque zone peut être affectée d'un coefficient de sensibilité, Cette cartographie à trois dimensions étant acquise, on bombarde virtuellement le composant 1 avec des ions lourds, des neutrons, des protons, ou autres selon des trajectoires variées 38 et 39. La corrélation entre les résultats obtenus par laser et les résultats obtenus en accélérateur n'est pas immédiate car les mécanismes d'interaction avec la matière sont différents. Mais il est connu des théories à partir desquelles ces corrélations sont possibles. Ceci veut dire qu'il est possible de déduire les zones sensibles aux particules à partir des zones sensibles au rayonnement laser.

Dans l'exemple, le rayon 38 tire à coté de la zone sensible 36, tandis que le rayon 39 tire en plein dans la zone 37. On mesure pour chaque rayon, en fonction de sa direction et de sa puissance, la survenance d'une panne ou non. Pour un niveau statistique d'activité de ces bombardements, on établit pour le composant 1, par simulation, une note de sensibilité.

**Revendications**

1. Procédé de caractérisation de la sensibilité aux interactions énergétiques dans un composant (1) électronique dans lequel,

 - on met le composant électronique en service,
 - on excite le composant électronique ainsi mis en service à l'aide (14) d'un rayonnement (15) laser,
 - on mesure (25) un défaut de fonctionnement du composant électronique mis en service correspondant à cette excitation, et
 - on établit une carte (Fig 5) de localisations d'intérêt dans le composant où ces interactions sont les plus fortes, **caractérisé en ce que**
 - on focalise (29) le rayonnement laser à différentes profondeurs (31) dans le composant et
 - on mesure les interactions énergétiques pour ces différentes profondeurs.

2. Procédé selon la revendication 1, **caractérisé en ce que** la focalisation est une localisation d'intérêt (1, 2, 3, 4, 5, 6, 7, 8, 9, 10, 11).

3. Procédé selon l'une des revendications 1 à 2, **caractérisé en ce que**

 - à titre de mesure d'interaction énergétique on mesure, par simulation laser (36-39), des interactions d'ions lourds et ou de protons et ou de neutrons.

4. Procédé selon l'une des revendications 1 à 3, **caractérisé en ce que**

 - pour une profondeur donnée on fait varier (35), de préférence par pas, la puissance du laser,
 - et on détermine une puissance critique du laser au delà de laquelle l'interaction devient critique.

5. Procédé selon l'une des revendications 1 à 4, **caractérisé en ce que**

 - on excite le composant par une face (12) d'une dalle (2) de ce composant, cette face étant de préférence opposée à celle sur laquelle sont effectuées des implantations d'impuretés.

6. Procédé selon la revendication 5, **caractérisé en ce que**

 - on fait un petit trou (16) dans une protection (13) de la dalle du composant,
 - ce petit trou étant de surface inférieure à une surface totale de la dalle du composant,
 - ce petit trou étant de surface supérieure à la trace d'un impact du rayonnement laser sur le composant,
 - cette trace d'impact étant de surface supérieure à la surface d'une cellule élémentaire électronique implantée dans le composant.

7. Procédé selon l'une des revendications 1 à 6, **caractérisé en ce que**

 - on mesure l'interaction en comparant un signal de sortie du composant à une valeur attendue, et
 - on détecte les conditions dans lesquelles cette comparaison (22) n'est plus conforme à un critère (23).

8. Procédé selon l'une des revendications 1 à 7, **caractérisé en ce que**

 - l'énergie du photon laser de la source laser est supérieure à la valeur de la bande interdite du composant semi-conducteur.

9. Dispositif de mise en oeuvre du procédé selon l'une des revendications 1 à 8.

**Patentansprüche**

1. Verfahren zur Charakterisierung der Empfindlichkeit gegenüber Energiewechselwirkungen in einer elektronischen Komponente (1), wobei:

   - die elektronische Komponente in Betrieb genommen wird,
   - die so in Betrieb genommene elektronische Komponente mit Hilfe einer Strahlung (15) eines Lasers (14) angeregt wird,
   - ein Funktionsfehler der in Betrieb genommenen elektronischen Komponente entsprechend dieser Anregung gemessen wird (25), und
   - eine Karte (FIG. 5) von Lokalisationen von Interesse in der Komponente erstellt wird, wo diese Wechselwirkungen am stärksten sind,
   **dadurch gekennzeichnet, dass**
   - die Laserstrahlung in unterschiedliche Tiefen (31) in der Komponente fokussiert wird (29), und
   - die Energiewechselwirkungen für diese unterschiedlichen Tiefen gemessen werden.

2. Verfahren nach Anspruch 1,
   **dadurch gekennzeichnet, dass** die Fokussierung für eine Lokalisierung von Interesse (1, 2, 3, 4, 5, 6, 7, 8, 9, 10, 11) ist.

3. Verfahren nach einem der Ansprüche 1 bis 2,
   **dadurch gekennzeichnet, dass**

   - zur Messung der Energiewechselwirkung durch Lasersimulation (36-39) Wechselwirkungen von schweren Ionen und/oder Protonen und/oder Neutronen gemessen werden.

4. Verfahren nach einem der Ansprüche 1 bis 3,
   **dadurch gekennzeichnet, dass**

   - für eine gegebene Tiefe, vorzugsweise schrittweise, die Leistung des Lasers variiert wird (35),
   - und eine kritische Leistung des Lasers bestimmt wird, über welche hinaus die Wechselwirkung kritisch wird.

5. Verfahren nach einem der Ansprüche 1 bis 4,
   **dadurch gekennzeichnet, dass**

   - die Komponente durch eine Fläche (12) einer Platte (2) dieser Komponente angeregt wird, wobei diese Fläche vorzugsweise jener gegenüberliegt, auf der Implantationen von Verunreinigungen durchgeführt werden.

6. Verfahren nach Anspruch 5,
   **dadurch gekennzeichnet, dass**

   - ein kleines Loch (16) in einem Schutz (13) der Platte der Komponente gebildet wird,
   - wobei dieses kleine Loch eine kleinere Fläche aufweist als eine Gesamtfläche der Platte der Komponente,
   - wobei dieses kleine Loch eine größere Fläche aufweist als die Spur eines Auftreffens der Laserstrahlung auf die Komponente,
   - wobei diese Spur des Auftreffens eine größere Fläche aufweist als die Fläche einer elektronischen Elementarzelle, die in die Komponente implantiert ist.

7. Verfahren nach einem der Ansprüche 1 bis 6,
   **dadurch gekennzeichnet, dass**

   - die Wechselwirkung durch einen Vergleich eines Ausgangssignals der Komponente mit einem erwarteten Wert gemessen wird, und
   - die Bedingungen detektiert werden, unter denen dieser Vergleich (22) nicht mehr mit einem Kriterium (23) konform ist.

8. Verfahren nach einem der Ansprüche 1 bis 7,
   **dadurch gekennzeichnet, dass**

- die Energie des Laserphotons der Laserquelle größer ist als der Wert der Bandlücke der Halbleiterkomponente.

**9.** Vorrichtung zur Durchführung des Verfahrens nach einem der Ansprüche 1 bis 8.

**Claims**

**1.** Method for characterizing sensitivity to energy interactions in an electronic component (1) in which:

- the electronic component is put into operation;
- the electronic component thus put into operation is excited using (14) laser radiation (15);
- a fault in the operation of the electronic component put into operation, corresponding to this excitation, is measured (25), and
- a map (Fig. 5) of locations of interest in the component, where these interactions are strongest, is produced, **characterized in that**:

- the laser radiation is focused (29) at various depths (31) in the component, and
- the energy interactions for these various depths are measured.

**2.** Method according to Claim 1, **characterized in that** the focusing is for a location of interest (1, 2, 3, 4, 5, 6, 7, 8, 9, 10, 11).

**3.** Method according to either of Claims 1 and 2, **characterized in that**:

- as a way of measuring energy interactions, interactions of heavy ions and/or protons and/or neutrons are measured by laser simulation (36-39).

**4.** Method according to one of Claims 1 to 3, **characterized in that**:

- for a given depth, the power of the laser is varied (35), preferably stepwise,
- and a critical power of the laser, beyond which the interaction becomes critical, is determined.

**5.** Method according to one of Claims 1 to 4, **characterized in that**:

- the component is excited via one face (12) of a plate (2) of this component, this face preferably being opposite that into which the implantations of impurities are carried out.

**6.** Method according to Claim 5, **characterized in that**:

- a small hole (16) is made in a protector (13) of the plate of the component;
- the surface area of this small hole being smaller than a total surface area of the plate of the component;
- the surface area of this small hole being larger than the mark of an impact of the laser radiation on the component;
- the surface area of this impact mark being larger than the surface area of an elementary electronic cell implanted in the component.

**7.** Method according to one of Claims 1 to 6, **characterized in that**:

- the interaction is measured by comparing an output signal from the component with an expected value, and
- the conditions in which this comparison (22) no longer conforms to a criterion (23) are detected.

**8.** Method according to one of Claims 1 to 7, **characterized in that**:

- the energy of the laser photon of the laser source is higher than the value of the band gap of the semiconductor component.

**9.** Device for implementing the method according to one of Claims 1 to 8.

**Fig. 1**

Profondeur de focalisation (µm)

Focalisation en z0=z1

Profondeur de focalisation (µm)

Focalisation en z0=z2<z1

**Fig. 2**

zo=z2<z1

zo=z1=zs

Profondeur de focalisation z

**Fig. 3**

Trace laser

Zone sensible de collection de charges du composant

Cas A (celui de la figure 1):

(z1)  (z2)  Laser ⟹ Le seuil est plus faible en z1 qu'en z2 ⟹ OK

Cas B: la zone de collection est trop étendue en x et y

(z1)  (z2) ⟹ Seuil identique ⟹ NON ou du moins difficile pratiquement

Cas C: la zone de collection est large, mais on se place en bord de zone

(z1)  (z2) ⟹ Le seuil est plus faible en z1 qu'en z2 ⟹ OK

**Fig. 4**

**Fig. 5**

Fig. 6

Fig. 7

**Fig. 8**

**Fig. 9**

**EP 2 008 115 B1**

## RÉFÉRENCES CITÉES DANS LA DESCRIPTION

**Documents brevets cités dans la description**

- GB 2248965 A